# EUROPEAN PATENT SPECIFICATION

(11) **EP 0 357 307 B1**
(45) Date of publication and mention of the grant of the patent: **29.11.1995**
(21) Application number: 89308415.2
(22) Date of filing: 18.08.1989
(51) Int. Cl.: H05K 1/02, H05K 3/22, G01R 31/28

(54) **Printed-wiring board**
Gedruckte Leiterplatte
Circuit imprimé

(30) Priority: 31.08.1988 JP 218123/88; 30.09.1988 JP 247751/88
(43) Date of publication of application: 07.03.1990
(73) Proprietor: NIPPON SEIKI CO. LTD., Nagaoka Niigata (JP)
(72) Inventor: Yazawa, Yoshiaki Nippon Seiki Co. Ltd., Nagaoka Niigata (JP)
(74) Representative: Votier, Sidney David

(56) References cited:
- JP-A-57 194 303
- PATENT ABSTRACTS OF JAPAN,vol. 10, no. 250 (P-491)August 28, 1986;& JP-A-61 077 771

## Description

### BACKGROUND OF THE INVENTION

### 1. Field of the Invention:

The present invention relates to a printed-wiring board formed by screen printing which has been adapted for detection of pattern deviation.

### 2. Description of the Prior Art:

In the manufacture of printed-wiring boards by screen printing, holes for through-hole connection are made in the board with the surface of the hole plated with copper, a plurality of layers of circuit patterns are printed on both front and rear surfaces, and copper on the unnecessary portions other than the circuit patterns is removed by etching. Then, a mask pattern formed of a resist layer is printed on the board, reference holes for punching work are made therein, and then a plurality of printed-wiring boards are obtained by punching work.

With such printed-wiring boards manufactured by the screen printing method, there is a problem that expansion or shrinkage of the screen affects the dimensions and accuracy of the wiring pattern.

When such a screen printing method is used, the screen easily expands or shrinks due to changes in the temperature and humidity, or the screen becomes expanded as it is used many times. Thus, deviation of the pattern is easily produced particularly in the type of screen having a plurality of layers of wiring patterns.

Further, in the case where a plurality of wiring circuit patterns having circular arc patterns are arranged on a printed-wiring board by the use of the screen printing method and the outer circumference of the product region corresponding to each wiring circuit pattern and the central portion of the circular arc pattern are punched so that the product is cut out to be concentric with the circular arc pattern, deviation of the circular arc pattern with respect to the center of the circular arc is liable to be produced in the product.

In the past, the deviation of the pattern due to expansion of the screen was checked by visual inspection by the operator so that a screen that was producing a large pattern deviation was replaced with a new one. However, since there was no means to accurately determine occurrence of the pattern deviation by visual inspection, it was often the case with such a prior art method that the time to replace the screen was lost and the use of the expanded screen was continued even when the pattern deviation exceeded its allowable limit, and therefore, there was a problem that a large number of defective products were produced.

### SUMMARY OF THE INVENTION

The present invention was made in view of the above described problems encountered in the prior art. Accordingly, an object of the present invention is to provide a board with which it is made easy to detect any deviation of the printed wiring circuit pattern occurring on the board.

The invention provides a method for producing a plurality of individual printed wiring boards according to claim 1.

### BRIEF DESCRIPTION OF THE DRAWINGS

FIG. 1 to FIG. 5 are drawings showing embodiments of the present invention. FIG. 1 is a front view showing patterns printed on the surface of a board;
FIG. 2 is a front view showing patterns printed on the rear surface of the board of FIG. 1;
FIG. 3 is a front view of an entire board showing a state where a plurality of layers columns of the patterns shown in FIG. 1 are printed thereon;
FIG. 4 is a front view of an individual punched printed-wiring board; and
FIG. 5 is a front view of a blank after being subjected to punching work.

### DETAILED DESCRIPTION OF THE PREFERRED EMBODIMENTS

A preferred embodiment of the present invention will be described below with reference to accompanying drawings.

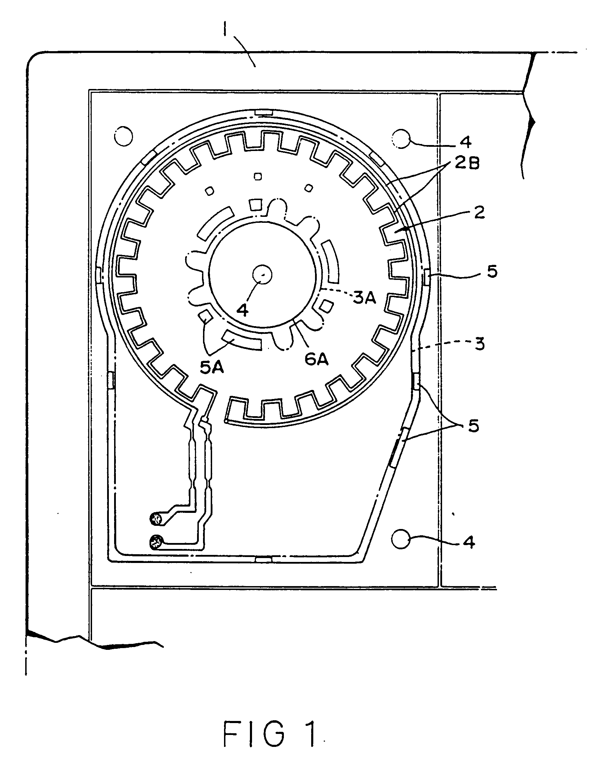

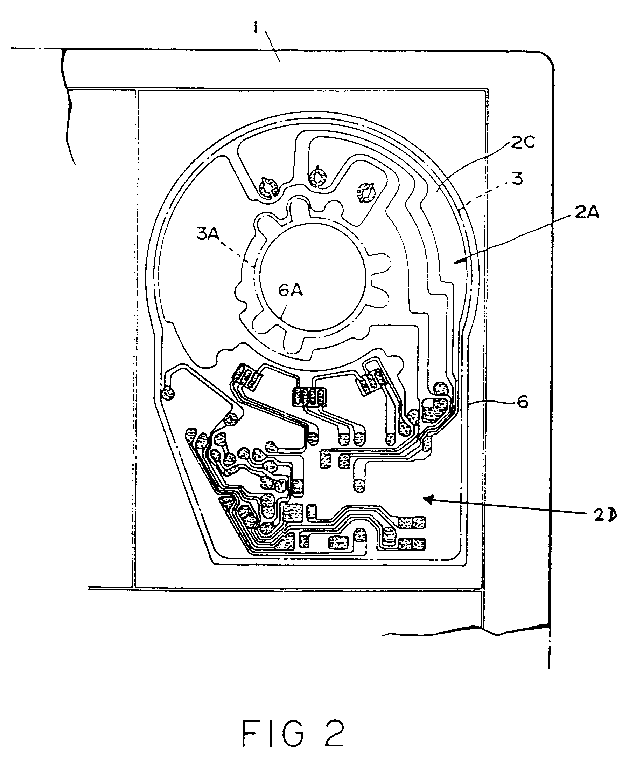

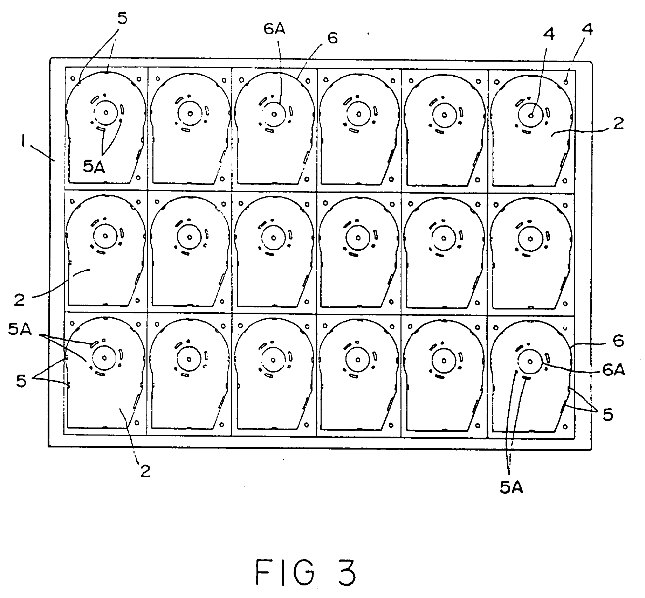

FIG. 1 to FIG. 5 show a printed-wiring board as a control circuit of a motor, in which reference numeral 1 denotes a board. On the front surface of the board 1, there are printed as shown in FIG. 3 a plurality of wiring patterns 2 of FIG. 1, and on the rear surface thereof, there are printed a plurality of columns of wiring patterns 2A as shown in FIG. 2 corresponding to the above described wiring patterns 2. Reference numerals 3 and 3A denote cutting lines indicated by dash-and-dot lines along which the board 1 with the wiring patterns 2, 2A formed thereon is punched, and the portion between the cutting lines 3 and 3A constitutes a product region (2D) on the board 1. Reference numerals 4 denote reference patterns for reference holes for punching work printed at positions on the board 1 outside the product region. By boring holes at the positions of the reference patterns 4, the reference holes 4A are made in the board.

In the present embodiment, reference patterns 4 on the board 1 are printed at three positions outside the product region (2D), i.e., on the outer side of the cutting line 3, and at one position on the board 1 in the internal non-product region, i.e., on the inner side of the cutting line 3A.

Reference numerals 5 denote a plurality of deviation detecting patterns printed on the surface of the board 1, outside of the cutting line 3, which becomes the outer circumference of the product region (2D). Reference numerals 5A denote a plurality of deviation detecting patterns printed on the product region (2D) on the side toward the interior of the cutting line 3A, which becomes the inner circumference of the product region. In the present embodiment, each of the deviation detecting patterns 5 and 5A is formed with a spacing corresponding to the allowable limit for the pattern deviation from the center of the product region, i.e., the position of the reference line referenced from the position of the cutting line 3, 3A. Reference numeral 6 denotes an outer circumferential line of a mask pattern formed of a resist layer and 6A denotes an inner circumferential line of the same. The mask patterns printed on the interior of the outer circumferential line 6 and the inner circumferential line 6A cover the wiring patterns 2, 2A and the detecting patterns 5, 5A.

By known screen printing, the wiring patterns 2, the reference patterns 4, and the deviation detecting patterns, 5, 5A are printed on the surface of the board 1 at the same time. Then the wiring patterns 2A are printed on the rear surface of the board 1 and each of the wiring patterns 2, 2A and the deviation detecting patterns 5, 5A are covered with a mask pattern. Holes are made at the positions of the reference pattern 4 whereby the reference holes 4A for punching work are made, and all the product regions are simultaneously punched along the cutting lines 3, 3A with the reference holes 4A used as the reference. Then, the distance between the cut plane 7 of each individual printed-wiring board 1A as the punched product region (2D) and the deviation detecting patterns 5, 5A is checked for determining whether or not the individual printed-wiring board 1A is good as a product.

When the distance between the cut plane 7 and the deviation detecting pattern 5, 5A, or the pattern deviation, is larger than the allowable limit, the screen is replaced with a new one.

In the present embodiment as described above, the board 1 is provided with deviation detecting patterns 5, 5A for checking for pattern deviation formed at the circumferential portions of each of a plurality of layers of wiring patterns 2. Hence, by only checking the distance between the cut plane 7 of each individual printed-wiring board 1A after being punched and the deviation detecting patterns 5, 5A, it is made possible to accurately and easily determine whether or not the condition of the pattern deviation is within a specified allowable limit, and thereby, it is prevented that the time for replacing the screen is lost.

The present invention is not limited to the above described embodiment and various modifications can be made without departing from the scope of the present invention as defined in the Claims. For example, the deviation detecting patterns may be formed at either of the outer circumferential portion and the inner circumferential portion, and the deviation detecting pattern may be continuously formed along the entire circumference of the product region or a plurality of the same may be formed at suitable positions along the circumference.

In the above described embodiment, there are formed a plurality of wiring patterns 2 having circular arc patterns 2B on the surface of the board 1 as shown in FIG. 1, and there are printed a plurality of wiring patterns 2A having circular arc patterns 2C, corresponding to the wiring pattern 2, on the rear surface of the board 1 as shown in FIG. 2.

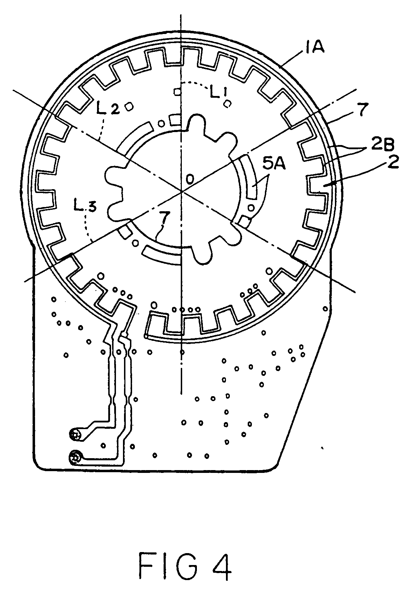

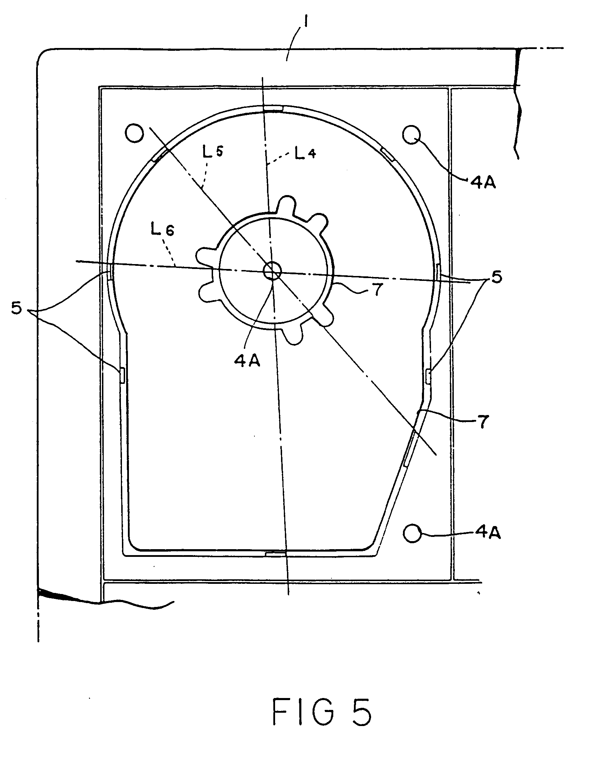

The deviation detecting patterns 5A are printed at concentric positions with the circular arc patterns 2B such that side ends of each pair of opposing deviation detecting patterns 5A are positioned along imaginary center lines L₁, L₂, L₃ of the circular arc patterns 2B as shown in FIG. 4. The deviation detecting patterns 5 are printed at concentric positions with the circular arc patterns 2B such that side ends of each pair of opposing deviation detecting patterns 5 are positioned along imaginary center lines L₄, L₅, L₆ of the circular arc patterns 2B as shown in FIG. 5.

By known screen printing, the wiring patterns 2 having the circular arc patterns 2B, the reference patterns 4, and the deviation detecting patterns 5 and 5A are simultaneously printed on the surface of the board 1 and the wiring patterns 2A having the circular arc wiring patterns 2C are printed on the rear surface of the board 1. Then, the wiring patterns 2 and 2A and the deviation detecting patterns 5 and 5A are covered with mask patterns. Then, the positions of the reference patterns 4 are bored so that the reference pattern holes 4A for punching work are made. Then, with the reference holes 4A used as the reference, all the product regions are simultaneously punched by cutting the outer circumferences of the product regions (2D) and central portions of the circular arc patterns 2B and 2C along the cutting lines 3 and 3A, respectively, and thereby, the manufacture of the individual printed-wiring boards 1A for the motor control circuit as the product is completed.

At this time, the individual printed wiring board 1A is punched to have a predetermined profile, and also, a fixing hole is made by punching its central portion so that the punched fixing hole of the individual printed wiring board 1A may be put on a bearing cylinder of a motor in a fit manner. Further, the generating coil of a frequency of a predetermined pattern provided by the circular arc patterns 2B disposed on the individual printed wiring board 1A and the rotor of the motor are aligned to be concentric.

Thus, when the circular arc patterns 2B come out of concentricity, the alignment of the frequency generating coil constituted of the circular arc patterns 2B with the rotor becomes poor, and thereby, a problem is posed that controlling of the rotating speed of the rotor sometimes becomes inaccurate.

In the present invention, however, whether the individual printed-wiring board 1A is good or not as the product is arranged to be determined on the basis of the imaginary center lines L₁, L₂, or L₃ obtained by means of the side end portions of the opposing deviation detecting patterns 5A, or the imaginary center lines L₄, L₅, or L₆ obtained by means of the side end portions of the deviation detecting patterns 5. More particularly, when the deviation of the distance between the position of the cut plane 7 on the imaginary center line L₁, L₂, L₃, L₄, L₅, L₆ and the side end portion of the deviation detecting patterns 5, 5A exceeds the allowable limit, the screen is replaced with a new one.

Thus, in the above described embodiment, there are disposed deviation detecting patterns 5 and 5A on the inner side or outer side of each product region of a plurality of wiring circuit patterns 2 arranged on a board 1 by screen printing, such that the deviation detecting pattern 5, 5A are positioned along at least one imaginary center line of the circular arc patterns 2B and concentrically with the circular arc patterns 2B. Therefore, by measuring the distance between the position of the circular cut plane 7 along the imaginary center line as a reference line obtained from the side end portion of the deviation detecting pattern 5, 5A and the position of the side end portion of the deviation detecting pattern 5, 5A, it is possible accurately and easily to determine whether or not the quantity of pattern deviation is within a specified allowable limit thereby ensuring that the screen is promptly replaced.

The present invention is not limited to the above described embodiment and various modifications can be made without departing from the scope of the present invention as defined in the claims. For example, provision of at least two deviation detecting patterns corresponding to one imaginary center line will be enough, and the deviation detecting patterns may be provided only on the exterior side or on the interior side of the cutting lines 3, 3A or on both the sides.

## Claims

1. A method for producing a plurality of individual printed wiring boards (1A) by screen printing wiring circuit patterns (2) having circular arc patterns (2C) on a board (1) and punching therefrom product regions (2D) corresponding to the wiring circuit patterns (2), characterised in that:
said individual printed wiring boards (1A) have printed thereon a plurality of deviation detecting patterns (5, 5A) for determining whether any deviation of the printed pattern (2) is within an allowable limit, said deviation detecting patterns (5, 5A) being printed at the time of the screen printing of said wiring circuit patterns (2), in the vicinity of the periphery (7) of each product region (2D), said deviation detecting patterns being located along at least one imaginary center line (L1, L2, L3, L4, L5, L6) of said circular arc patterns (2C) and at concentric position with said circular arc patterns (2C).

2. A method according to Claim 1, wherein said board (1) is provided, at the time of the screen printing of said wiring circuit patterns (2) with reference patterns (4, 4A) serving as a reference for the position to be punched.

3. A method according to any of the preceding claims, wherein said deviation detecting patterns (5, 5A) are printed at least at either an outer circumference (5) or an inner circumference (5A) of the product region (2D).

4. A method according to any of the preceding claims, wherein said board (1) is provided, at the time of the screen printing of said wiring circuit patterns (2), with deviation detecting patterns (5, 5A) for determining whether or not the quantity of deviation is within an allowable limit at either or both of the interior (3A) and the exterior (3) of each product region (2D) of each wiring circuit pattern (2).

## Patentansprüche

1. Verfahren zur Herstellung einer Vielzahl einzelner gedruckter Schaltungen (1A) durch Siebdrucken von Schaltungsmustern (2) mit kreisförmigen Bogenmustern (2C) auf eine Platte (1) und durch daraus Stanzen von Produktbereichen (2D) entsprechend den Schaltungsmustern (2), **dadurch gekennzeichnet, daß** die einzelnen gedruckten Schaltungen (1A) eine Vielzahl von Abweichungserfassungsmustern (5, 5A) zur Bestimmung, ob eine Abweichung des gedruckten Musters (2) innerhalb einer zulässigen Grenze ist, aufgedruckt haben, wobei die Abweichungserfassungsmuster (5, 5A) zu der Zeit des Siebdruckens der Schaltungsmuster (2) in der Nähe der Begrenzungsfläche (7) jedes Produktbereichs (2D) gedruckt werden und die Abweichungserfassungsmuster entlang mindestens einer gedachten Mittellinie (L1, L2, L3 , L3, L4, L5 ,L6) der kreisförmigen Bogenmuster (2C) und in konzentrischer Position mit den kreisförmigen Bogenmustern (2C) angeordnet werden.

2. Verfahren nach Anspruch 1, bei welchem die Platte (1) zur Zeit des Siebdruckens der Schaltungsmuster (2) mit Bezugsmustern (4, 4A), die als Bezug für die zu stanzende Position dienen, versehen wird.

3. Verfahren nach einem der vorhergehenden Ansprüche, bei welchem die Abweichungserfassungsmuster (5, 5A) mindestens bei entweder einem äußeren Umfang (5) oder einem inneren Umfang (5A) des Produktbereichs (2D) gedruckt werden.

4. Verfahren nach einem der vorhergehenden Ansprüche, bei welchem die Platte (1) zur Zeit des Siebdruckens der Schaltungsmuster (2) mit Abweichungserfassungsmustern (5, 5A) zur Bestimmung, ob oder ob nicht das Ausmaß der Abweichung innerhalb einer zulässigen Grenze zu dem Inneren (3A) und oder dem Äußeren (3) eines jeden Produktbereichs (2D) eines jeden Schaltungsmusters (2) ist, versehen wird.

## Revendications

1. Procédé de production d'une pluralité de plaques individuelles de câblage imprimé (1A) par sérigraphie de dessins de circuit de câblage (2) constitués par des dessins en arc circulaire (2C) sur une plaque (1) et en poinçonnant sur celle-ci des zones de produit (2D) correspondant aux dessins de circuit de câblage, caractérisé en ce que:
lesdites plaques individuelles de câblage imprimé (1A) disposent, imprimée au-dessus, d'une pluralité de dessins de détection de décalage (5,5A) destiné à déterminer si un décalage quelconque du dessin imprimé (2) est compris dans une limite permise, lesdits dessins de détection de décalage (5, 5A) étant imprimés au moment de la sérigraphie desdits dessins de circuit de câblage (2), à proximité de la périphérie (7) de chaque zone de produit (2D), lesdits dessins de détection de décalage étant situés le long d'au moins une ligne imaginaire passant par le centre (L1, L2, L3, L4, L5, L6) desdits dessins en arc circulaire (2C), et à une position concentrique par rapport auxdits dessins en arc circulaire (2C).

2. Procédé selon la revendication 1, dans lequel ladite plaque (1) est pourvue, au moment de la sérigraphie desdits dessins de circuit de câblage (2), de dessins de référence (4, 4A) servant de référence pour la position à poinçonner.

3. Procédé selon l'une quelconque des revendications précédentes, dans lequel lesdits dessins de détection de décalage (5, 5A) sont imprimés au moins sur l'une des circonférence externe (5) ou circonférence interne (5A) de la zone de produit (2D).

4. Procédé selon l'une quelconque des revendications précédentes dans lequel ladite plaque (1) est pourvue, au moment de la sérigraphie desdits dessins de circuit de câblage (2), de dessins de détection de décalage (5, 5A) destinés à déterminer si la valeur du décalage est comprise ou pas dans une limite permise soit à l'intérieur (3A) soit à l'éxtérieur (3), ou des deux côtés, de chaque zone de produit (2D) de chaque dessin de circuit de câblage (2).
